# EUROPEAN PATENT APPLICATION

(11) **EP 1 505 122 A1**
(43) Date of publication of application: **09.02.2005**
(21) Application number: 03730499.5
(22) Date of filing: 14.05.2003
(51) Int. Cl.: C08L 83/05, C08J 5/18, H05K 9/00, C08L 83/07

(54) **CURABLE SILICONE COMPOSITION FOR THE PRODUCTION OF COMPOSITE SOFT MAGNETIC MATERIALS, AND COMPOSITE SOFT MAGNETIC MATERIALS**

(30) Priority: 14.05.2002 JP 2002138719
(71) Applicant: Dow Corning Toray Silicone Co., Ltd., Tokyo 100-0005 (JP); TDK Corporation, Chuo-ku, Tokyo 103-0027 (JP)
(72) Inventor: SEKIBA, K.; c/o Dow Corning Toray Silicone Co Ltd, Chiba 299-0108 (JP); TANAKA, Takashi; c/o TDK Corporation, Chuo-ku, Tokyo 103-0027 (JP); SASAKI, Hisanori; c/o TDK Corporation, Chuo-ku, Tokyo 103-0027 (JP); TAKAHASHI, Hideomi; c/o TDK Corporation, Chuo-ku, Tokyo 103-0027 (JP)
(74) Representative: Kyle, Diana
(86) International application number: PCT/JP2003/006031
(87) International publication number: WO 2003/095560

(57) **Abstract**

A curable silicone composition for the production of composite soft magnetic materials comprising at least (A) a curable organopolysiloxane, (B) a curing agent, (C) a soft magnetic powder, and (D) an organosiloxane represented by the general formula: [R¹ₐR²₍₃₋ₐ₎SiO(R²₂SiO)ₙ]_{b}SiR²_{[4-(b+c)]}(OR³)_{c} (where R¹ is a monovalent hydrocarbon group having an aliphatic unsaturated bond or bonds, R² are similar or different monovalent hydrocarbon groups having no aliphatic unsaturated bonds, R³ is an alkyl group or an alkoxyalkyl group, the subscript «a» is an integer from 1 to 3, the subscript «b» is an integer from 1 to 3, the subscript «c» is an integer from 1 to 3, the subscript «b+c» is an integer from 2 to 4 and the subscript «n» is an integer of 0 or greater), as well as composite soft magnetic materials obtained by curing said composition. The invention provides a curable silicone composition capable of producing the above-mentioned composite soft magnetic materials despite containing a large amount of a soft magnetic powder used to obtain composite soft magnetic materials of superior electromagnetic wave absorption characteristics, as well as composite soft magnetic materials of superior electromagnetic wave absorption characteristics and of superior flame retardancy and thermal conductivity.

## Description

### Technical Field

The present invention relates to a curable silicone composition for the production of composite soft magnetic materials and to composite soft magnetic materials. More specifically, it relates to a curable silicone composition capable of producing the above-mentioned composite soft magnetic materials despite containing a large amount of a soft magnetic powder used to obtain composite soft magnetic materials of superior electromagnetic wave absorption characteristics, as well as to composite soft magnetic materials of superior electromagnetic wave absorption characteristics and of superior flame retardancy and thermal conductivity.

In addition, in the present invention, the term "electromagnetic wave absorption characteristics" refers to a broad range of characteristics including not only far electromagnetic field absorption, but also near electromagnetic field absorption.

### Background Art

Curable silicone compositions containing soft magnetic powders, as well as composite soft magnetic materials obtained by curing them, are publicly known, for instance, from Japanese Laid Open (Unexamined or Kokai) Patent Application No. 2000-294977, Japanese Laid Open (Unexamined or Kokai) Patent Application No. 2001-44687, Japanese Laid Open (Unexamined or Kokai) Patent Application No. 2001-294752, and Japanese Laid Open (Unexamined or Kokai) Patent Application No. 2001-11918. Generally speaking, curable silicone compositions with high loadings of soft magnetic powder are necessary for the improvement of the electromagnetic wave absorption characteristics of composite soft magnetic materials.

However, the problem is that homogeneous compositions not obtained, or the moldability of the resultant compositions deteriorates when curable silicone compositions are highly loaded with soft magnetic powders.

The present inventors arrived at the present invention as a result of in-depth investigations into the above-mentioned problems.

Namely, it is an object of the present invention to provide a curable silicone composition capable of producing the above-mentioned composite soft magnetic materials despite containing a large amount of soft magnetic powder used to obtain composite soft magnetic materials of superior electromagnetic wave absorption characteristics, as well as composite soft magnetic materials of superior electromagnetic wave absorption characteristics and of superior flame retardancy and thermal conductivity.

### Disclosure of the Invention

The inventive curable silicone composition for the production of composite soft magnetic materials is characterized by comprising at least (A) a curable organopolysiloxane, (B) a curing agent, (C) a soft magnetic powder, and (D) an organosiloxane represented by the general formula:

[R¹ ₐR² ₍₃₋ₐ₎SiO(R² ₂SiO)ₙ]_{b}SiR² _{[4-(b+c)]}(OR³)_{c}

(where R¹ is a monovalent hydrocarbon group having an aliphatic unsaturated bond or bonds, R² are similar or different monovalent hydrocarbon groups having no aliphatic unsaturated bonds, R³ is an alkyl group or an alkoxyalkyl group, the subscript «a» is an integer from 1 to 3, the subscript «b» is an integer from 1 to 3, the subscript «c» is an integer from 1 to 3, the subscript «b+c» is an integer from 2 to 4, and the subscript «n» is an integer of 0 or greater).

In addition, the composite soft magnetic materials of the present invention are characterized in that they are obtained by curing the above-described composition.

### Detailed Description of the Invention

First of all, detailed explanations will be provided regarding the inventive curable silicone composition for the production of composite soft magnetic materials.

Component (A), the main ingredient of the present composition, is a curable organopolysiloxane, and component (B) is a curing agent used for cross-linking the above-mentioned component (A). There are no limitations concerning the consistency of cured products obtained by curing the present composition, which may be, for instance, high-hardness rubber-like, low-hardness rubber-like, or gel-like. In addition, there are no limitations concerning the cure mechanism of the present composition. Hydrosilation reactions, organic peroxide-based free radical reactions, and condensation reactions are suggested as examples thereof, with hydrosilation reactions being preferable because the composition can be cured fast by heating while generating no by-products.

When the present composition is cured by a hydrosilation reaction, component (A) is preferably an organopolysiloxane having an average of at least 0.1 silicon-bonded alkenyl groups per molecule, more preferably, an organopolysiloxane having an average of at least 0.5 silicon-bonded alkenyl groups per molecule, and especially preferably, an organopolysiloxane having an average of at least 0.8 silicon-bonded alkenyl groups per molecule. This is due to the fact that the resultant composition tends to fail to completely cure if the average number of silicon-bonded alkenyl groups per molecule is below the lower limit of the above-mentioned ranges.

Some examples of the alkenyl groups in the organopolysiloxane include, for instance, vinyl, allyl, butenyl, pentenyl, and hexenyl, with vinyl being preferable. In addition, examples of silicon-bonded groups other than the alkenyl groups in the organopolysiloxane include, for instance, methyl, ethyl, propyl, butyl, pentyl, hexyl, and other alkyl groups; cyclopentyl, cyclohexyl, and other cycloalkyl groups; phenyl, tolyl, xylyl, and other aryl groups; benzyl, phenetyl, and other aralkyl groups; 3,3,3-trifluoropropyl, 3-chloropropyl, and other halogenated alkyl groups, with alkyl and aryl groups being preferable, and methyl and phenyl being especially preferable. In addition, while there are no limitations concerning the viscosity of the organopolysiloxane at 25°C, it is preferably in the range of from 50 to 100,000 mPa·s and, especially preferably, in the range of from 100 to 50,000 mPa·s. This is due to fact that the physical characteristics of the resultant silicone cured product tend to noticeably decrease when its viscosity at 25°C is below the lower limit of the above-mentioned ranges and, on the other hand, to the fact that the handleability of the resultant curable silicone composition tends to conspicuously deteriorate when it exceeds the upper limit of the above-mentioned ranges. There are no limitations concerning the molecular structure of such an organopolysiloxane, which may be, for instance, linear, branched, partially branched linear, or dendritic (dendrimer-like), and is preferably linear or partially branched linear. In addition, the organopolysiloxane may be a homopolymer having one of the above-mentioned molecular structures, a copolymer comprising these molecular structures, or a mixture of such polymers.

Examples of such organopolysiloxanes include, for instance, dimethylpolysiloxane having both ends of the molecular chain blocked by dimethylvinylsiloxy groups, dimethylpolysiloxane having both ends of the molecular chain blocked by methylphenylvinylsiloxy groups, copolymer of methylphenylsiloxane and dimethylsiloxane having both ends of the molecular chain blocked by dimethylvinylsiloxy groups, copolymer of methylvinylsiloxane and dimethylsiloxane having both ends of the molecular chain blocked by dimethylvinylsiloxy groups, copolymer methylvinylsiloxane and dimethylsiloxane having both ends of the molecular chain blocked by trimethylsiloxy groups, methyl(3,3,3-trifluoropropyl)polysiloxane having both ends of the molecular chain blocked by dimethylvinylsiloxy groups, copolymer of methylvinylsiloxane and dimethylsiloxane having both ends of the molecular chain blocked by silanol groups, copolymer of methylphenylsiloxane, methylvinylsiloxane, and dimethylsiloxane having both ends of the molecular chain blocked by silanol groups, and organosiloxane copolymer consisting of siloxane units represented by the formula (CH₃)₃SiO_{1/2}, siloxane units represented by the formula (CH₃)₂(CH₂=CH)SiO_{1/2}, siloxane units represented by the formula CH₃SiO_{3/2}, and siloxane units represented by the formula (CH₃)₂SiO_{2/2}.

When the present composition is cured by a hydrosilation reaction, component (B) comprises a platinum catalyst and an organopolysiloxane having an average of at least two silicon-bonded hydrogen atoms per molecule.

Examples of silicon-bonded groups other than the hydrogen atoms in the organopolysiloxane include, for instance, methyl, ethyl, propyl, butyl, pentyl, hexyl, and other alkyl groups; cyclopentyl, cyclohexyl, and other cycloalkyl groups; phenyl, tolyl, xylyl, and other aryl groups; benzyl, phenetyl, and other aralkyl groups; 3,3,3-trifluoropropyl, 3-chloropropyl, and other halogenated alkyl groups, with alkyl and aryl groups being preferable, and methyl and phenyl being especially preferable. In addition, while there are no limitations concerning the viscosity of the organopolysiloxane at 25°C, it is preferably in the range of from 1 to 100,000 mPa·s and, especially preferably, in the range of from 1 to 5,000 mPa·s. There are no limitations concerning the molecular structure of such an organopolysiloxane, which may be, for instance, linear, branched, partially branched linear, or dendritic (dendrimer-like). The organopolysiloxane may be a homopolymer having one of the above-mentioned molecular structures, a copolymer comprising these molecular structures, or a mixture of such polymers.

Examples of such organopolysiloxanes include, for instance, dimethylpolysiloxane having both ends of the molecular chain blocked by dimethylhydrogensiloxy groups, copolymer of methylhydrogensiloxane and dimethylsiloxane having both ends of the molecular chain blocked by trimethylsiloxy groups, copolymer of methylhydrogensiloxane and dimethylsiloxane having both ends of the molecular chain blocked by dimethylhydrogensiloxy groups, and organosiloxane copolymer consisting of siloxane units represented by the formula (CH₃)₃SiO_{1/2}, siloxane units represented by the formula (CH₃)₂HSiO_{1/2}, and siloxane units represented by the formula SiO_{4/2}.

In the present composition, the content of the organopolysiloxane is such that the quantity of silicon-bonded hydrogen atoms in this component per 1 mol of the silicon-bonded alkenyl groups in component (A) is preferably in the range of from 0.1 to 10 mol and, especially preferably, in the range of from 0.1 to 5 mol. This is due to the fact that the resultant curable silicone composition tends to fail to completely cure if the content of the component is below the lower limit of the above-mentioned ranges, and, on the other hand, to the fact that the resultant silicone cured product becomes extremely rigid and numerous cracks appear on its surface when the content exceeds the upper limit of the above-mentioned ranges.

In addition, the platinum catalyst is exemplified by chloroplatinic acid, alcohol solutions of chloroplatinic acid, olefin complexes of platinum, alkenylsiloxane complexes of platinum, and carbonyl complexes of platinum. The content of the platinum catalyst is preferably such that the quantity of platinum metal in the catalyst relative to component (A), in terms of weight units, is in the range of from 0.01 to 1,000 ppm, and, especially preferably, in the range of from 0.1 to 500 ppm. This is due to the fact that the resultant curable silicone composition tends to fail to completely cure when the content of the component is below the lower limit of the above-mentioned ranges, and, on the other hand, to the fact that the rate of cure of the resultant curable silicone composition does not considerably increase even if it exceeds the upper limits of the above-mentioned ranges.

In addition, when the present composition is cured by a free radical reaction, there are no particular limitations concerning the organopolysiloxane of component (A), but it is preferably an organopolysiloxane having at least one silicon bonded alkenyl group per molecule.

The alkenyl groups of the organopolysiloxane are exemplified by the same alkenyl groups as those mentioned above and are preferably represented by vinyl. In addition, in this organopolysiloxane, silicon bonded groups other than the alkenyl groups are exemplified by the same alkyl, cycloalkyl, aryl, aralkyl, and halogenated alkyl groups as those mentioned above and are preferably represented by alkyl and aryl groups, with methyl and phenyl being especially preferable. In addition, although there are no limitations concerning the viscosity of the organopolysiloxane at 25°C, the viscosity is preferably in the range of from 50 to 100,000 mPa·s and, especially preferably, in the range of from 100 to 50,000 mPa·s. This is due to fact that the physical characteristics of the resultant silicone cured product tend to noticeably decrease when its viscosity at 25°C is below the lower limit of the above-mentioned ranges and, on the other hand, to the fact that the handleability of the resultant curable silicone composition tends to conspicuously deteriorate when it exceeds the upper limit of the above-mentioned ranges. There are no limitations concerning the molecular structure of such an organopolysiloxane, which may be, for instance, linear, branched, partially branched linear, or dendritic (dendrimer-like), and is preferably linear or partially branched linear. In addition, the organopolysiloxane may be a homopolymer having one of the above-mentioned molecular structures, a copolymer comprising these molecular structures, or a mixture of such polymers.

Examples of such organopolysiloxanes include, for instance, dimethylpolysiloxane having both ends of the molecular chain blocked by dimethylvinylsiloxy groups, dimethylpolysiloxane having both ends of the molecular chain blocked by methylphenylvinylsiloxy groups, copolymer of methylphenylsiloxane and dimethylsiloxane having both ends of the molecular chain blocked by dimethylvinylsiloxy groups, copolymer of methylvinylsiloxane and dimethylsiloxane having both ends of the molecular chain blocked by dimethylvinylsiloxy groups, copolymer methylvinylsiloxane and dimethylsiloxane having both ends of the molecular chain blocked by trimethylsiloxy groups, methyl(3,3,3-trifluoropropyl)polysiloxane having both ends of the molecular chain blocked by dimethylvinylsiloxy groups, copolymer of methylvinylsiloxane and dimethylsiloxane having both ends of the molecular chain blocked by silanol groups, copolymer of methylphenylsiloxane, methylvinylsiloxane, and dimethylsiloxane having both ends of the molecular chain blocked by silanol groups, and organosiloxane copolymer consisting of siloxane units represented by the formula (CH₃)₃SiO_{1/2}, siloxane units represented by the formula (CH₃)₂(CH₂=CH)SiO_{1/2}, siloxane units represented by the formula CH₃SiO_{3/2}, and siloxane units represented by the formula (CH₃)₂SiO_{2/2}.

In addition, when the present composition is cured by a free radical reaction, component (B) is an organic peroxide. The organic peroxides are exemplified by benzoyl peroxide, p-methylbenzoyl peroxide, dicumyl peroxide, 2,5-dimethyl-bis(2,5-t-butylperoxy)hexane, di-*t*-butyl peroxide, and *t*-butyl perbenzoate. The content of the organic peroxide is preferably in the range of from 0.1 to 5 parts by weight per 100 parts by weight of component (A).

In addition, when the present composition is cured by a condensation reaction, component (A) is an organopolysiloxane having at least two silanol groups or silicon-bonded hydrolyzable groups per molecule. Examples of the silicon-bonded hydrolyzable groups of the organopolysiloxane include, for instance, methoxy, ethoxy, propoxy, and other alkoxy groups; vinyloxy, isopropenyloxy, 1-ethyl-2-methylvinyloxy, and other alkenoxy groups; methoxyethoxy, ethoxyethoxy, methoxypropoxy, and other alkoxyalkoxy groups; acetoxy, octanoyloxy, and other acyloxy groups; dimethyl ketoxime, methyl ethyl ketoxime, and other ketoxime groups; dimethylamino, diethylamino, dibutylamino, and other amino groups; dimethylaminoxy, diethylaminoxy, and other aminoxy groups; and N-methylacetamido, N-ethylacetamido, and other amido groups. In addition, in this organopolysiloxane, silicon-bonded groups other than the silanol groups or silicon-bonded hydrolyzable groups are exemplified by the same alkyl, cycloalkyl, alkenyl, aryl, aralkyl, and halogenated alkyl groups as those mentioned above. Also, while there are no limitations concerning the viscosity of the organopolysiloxane at 25°C, it is preferably in the range of from 20 to 100,000 mPa·s and, especially preferably, in the range of from 100 to 100,000 mPa·s. Additionally, organosiloxanes of component (D) are not included in this component.

Examples of such organopolysiloxanes include, for instance, dimethylpolysiloxane having both ends of the molecular chain blocked by silanol groups, copolymer of methylphenylsiloxane and dimethylsiloxane having both ends of the molecular chain blocked by silanol groups, dimethylpolysiloxane having both ends of the molecular chain blocked by trimethoxysiloxy groups, copolymer of methylphenylsiloxane and dimethylsiloxane having both ends of the molecular chain blocked by trimethoxysiloxy groups, dimethylpolysiloxane having both ends of the molecular chain blocked by methyldimethoxysiloxy groups, dimethylpolysiloxane having both ends of the molecular chain blocked by triethoxysiloxy groups, and dimethylpolysiloxane having both ends of the molecular chain blocked by trimethoxysilylethyl groups.

In addition, when the present composition is cured by a condensation reaction, component (B) is a silane having at least three silicon-bonded hydrolyzable groups per molecule or a partial hydrolyzate thereof, and, if necessary, a condensation reaction catalyst.

The silicon-bonded hydrolyzable groups of the silane are exemplified by the same alkoxy, alkoxyalkoxy, acyloxy, ketoxime, alkenoxy, amino, aminoxy, and amido groups as those mentioned above. In addition, in the silane, silicon bonded groups other than the hydrolyzable groups are exemplified by the same alkyl, cycloalkyl, alkenyl, aryl, aralkyl, and halogenated alkyl groups as those mentioned above. Examples of such silanes and their partial hydrolizates include, for instance, methyltriethoxysilane, vinyltriethoxysilane, vinyltriacetoxysilane, and ethyl orthosilicate.

In the present composition, the content of the silane or its partial hydrolyzate is preferably in the range of from 0.01 to 20 parts by weight, and, especially preferably, in the range of from 0.1 to 10 parts by weight per 100 parts by weight of component (A). This is due to the fact that the storage stability and adhesive property of the resultant composition decreases when the content of the silane or its partial hydrolyzate is below the lower limit of the above-mentioned ranges, and, on the other hand, the cure of the resultant composition noticeably slows down when it exceeds the upper limit of the above-mentioned ranges.

Also, the condensation reaction catalyst is an optional component and is not essential, for instance, when a silane having aminoxy, amino, and ketoxime groups is used as the curing agent. Examples of such condensation reaction catalysts include, for instance, tetrabutyl titanate, tetraisopropyl titanate, and other organotitanates; diisopropoxy bis(acetyl acetato)titanium, diisopropoxy bis(ethyl acetacetato)titanium, and other organotitanium chelate compounds; aluminum tris(acetyl acetonate), aluminum tris(ethyl acetoacetate), and other organic aluminum compounds; zirconium tetra(acetyl acetonate), zirconium tetrabutylate, and other organic zirconium compounds; dibutyltin dioctoate, dibutyltin dilaurate, dibutyltin-2-ethylhexoate, and other organotin compounds; tin naphthenate, tin oleate, tin butyrate, cobalt naphthenate, zinc stearate, and other metal salts of organic carboxylic acids; hexylamine, dodecylamine phosphate, and other amine compounds and their salts; benzyltriethylammonium acetate and other quaternary ammonium salts; potassium acetate, lithium nitrate, and other of lower fatty acid salts of alkali metals; dimethylhydroxylamine, diethylhydroxylamine, and other dialkylhydroxylamines; and, in addition, organosilicon compounds containing guanidyl groups.

There are no limitations concerning the content of the condensation reaction catalyst, but preferably, the content is in the range of from 0.01 to 20 parts by weight, and, especially preferably, in the range of from 0.1 to 10 parts by weight per 100 parts by weight of component (A). This is due to the fact that, when this catalyst is essential, the resultant composition tends to fail to completely cure if the content is below the lower limit of the above-mentioned ranges, and, on the other hand, the storage stability of the resultant composition tends to decrease when it exceeds the upper limit of the above-mentioned ranges.

Component (C) is a soft magnetic powder used to impart electromagnetic wave absorption characteristics to composite soft magnetic materials formed by curing the present composition. Examples of such powders include, for instance, soft magnetic metal powders or magnetic oxide powders (ferrite powders). Such soft magnetic metal powders are exemplified by iron powder (carbonyl iron powder) or powders of iron-based alloys such as Fe-Si alloys, Fe-Al alloys, Fe-Si-Al alloys, Fe-Si-Cr alloys, Fe-Ni alloys, Fe-Ni-Co alloys, Fe-Ni-Mo alloys, Fe-Co alloys, Fe-Si-Al-Cr alloys, Fe-Si-B alloys, Fe-Si-Co-B alloys, etc. In addition, such ferrite powders are exemplified by Mn-Zn ferrites, Mn-Mg-Zn ferrites, Mg-Cu-Zn ferrites, Ni-Zn ferrites, Ni-Cu-Zn ferrites, Cu-Zn ferrites, and other spinel ferrites, and W-type, Y-type, Z-type, M-type and other hexagonal ferrites. Because ferrite powders are noncombustible, from the standpoint of flame retardancy, they are more efficient than metal magnetic powders. Furthermore, because ferrites generally have higher electrical resistance than metallic magnetic materials, they are more suitable when insulating properties are required. In addition, in terms of shape, they may be granular, spherical, or oblate. Among the above-mentioned shapes, using oblate soft magnetic powders is preferable when modem electromagnetic noise frequencies are taken into consideration. This is due to the fact that imparting an oblate shape to a soft magnetic powder suppresses the diamagnetic field acting on the soft magnetic powder and, as a result, magnetic resonance phenomena can be produced at frequencies of 1 GHz or less, which are currently at the center of the noise problem. If D₅₀ is the mean particle size obtained when the value of 50% is reached in the process of summing up weight starting from small particle sizes, as determined using a particle size meter, then the size of the soft magnetic powder is preferably such that the value of D₅₀ is in the range of from 1 to 50 *µ*m and, even more preferably, in the range of from 3 to 30 *µ*m. In addition, when the shape of the soft magnetic powder is oblate, the aspect ratio is preferably in the range of from 5 to 100, and, especially preferably, in the range of from 10 to 50. Among such soft magnetic powders, it is preferable to use oblate soft magnetic powders. This is due to the fact that with soft magnetic metal powders, it is relatively easy to impart an oblate shape to the material, and, as a result, it is possible to achieve high electromagnetic wave absorption performance at frequencies of 1GHz or less, which are currently at the core of the noise problem, as mentioned above. Also, oblate soft magnetic metal powders have a high specific surface areas and high activity and, as a result, from the standpoint of the safety of the composite soft magnetic material fabrication process as well as the flame retardancy of the composite soft magnetic materials, it is preferable for the surface of such powders to be subjected to oxidizing treatment. In addition, with such soft magnetic powders, a single type or, depending on the intended use, several types of powder can be used together.. Component (C) can be prepared in accordance with the preparation processes described in Japanese Patent Publication No. Sho 54-27557 and Japanese Patent Publication No. 2,523,388.

There are no limitations concerning the content of component (C), however, in order to form composite soft magnetic materials possessing excellent electromagnetic wave absorption characteristics, it is preferable for the content to be in the range of from 40 to 1,000 parts by weight per 100 parts by weight of component (A). In order to form composite soft magnetic materials of particularly superior electromagnetic wave absorption characteristics, the content of component (C) should be preferably in the range of from 50 to 1,000 parts by weight, more preferably, in the range of from 100 to 1,000 parts by weight, and, especially preferably, in the range of from 200 to 1,000 parts by weight per 100 parts by weight of component (A). On the other hand, in order to obtain a curable silicone composition for the production of composite soft magnetic materials of superior moldability, the content of component (C) should be preferably in the range of from 40 to 900 parts by weight, and especially preferably, in the range of from 40 to 800 parts by weight per 100 parts by weight of component (A). With account taken of the above, the content of component (C) should be preferably in the range of from 50 to 900 parts by weight, even more preferably, in the range of from 100 to 900 parts by weight, and especially preferably, in the range of from 200 to 800 parts by weight per 100 parts by weight of component (A). This is due to the fact that the magnetic characteristics of the resultant composite soft magnetic material tend to be insufficient when the content of component (C) is below the lower limit of the above-mentioned ranges and, on the other hand, uniformly dispersing component (C) in the resultant component (A) tends to become impossible and molding becomes difficult when it exceeds the upper limit of the above-mentioned ranges.

Component (D), which is represented by the general formula:

[R¹ ₐR² ₍₃₋ₐ₎SiO(R² ₂SiO)ₙ]_{b}SiR² _{[4-(b+c)]}(OR³)_{c}

is an organosiloxane used to prevent deterioration in the moldability of the resultant composition even when the present composition is highly loaded with component (C). R¹ in the formula above is a monovalent hydrocarbon group having aliphatic unsaturated bonds. Examples of such groups include, for instance, vinyl, allyl, butenyl, hexenyl, decenyl, undecenyl, dodecenyl, tridecenyl, tetradecenyl, pentadecenyl, hexadecenyl, heptadecenyl, octadecenyl, nonadecenyl, eicosenyl, and other linear alkenyl groups; isopropenyl, 2-methyl-2-propenyl, 2-methyl-10-undecenyl, and other branched alkenyl groups; vinylcyclohexyl, vinylcyclododecyl, and other cyclic alkyl groups having aliphatic unsaturated bonds; vinylphenyl and other aryl groups with aliphatic unsaturated bonds; vinylbenzyl, vinylphenetyl, and other aralkyl groups with aliphatic unsaturated bonds. Preferably, however, such groups are represented by linear alkenyl groups and, especially preferably, by vinyl, allyl, and hexenyl. While there are no limitations concerning the position of the aliphatic unsaturated bonds in R', preferably, it is located away from bonded silicon atoms. Also, R² in the formula above are similar or different monovalent hydrocarbon groups having no aliphatic unsaturated bonds, examples of which include, for instance, methyl, ethyl, propyl, butyl, hexyl, decyl, and other linear alkyl groups; isopropyl, *tert*-butyl, isobutyl, and other branched alkyl groups; cyclohexyl and other cyclic alkyl groups; phenyl, tolyl, xylyl, and other aryl groups; benzyl, phenetyl, and other aralkyl groups, with alkyl and aryl groups being preferable, alkyl groups having from 1 to 4 carbon atoms being even more preferable, and methyl and ethyl being especially preferable. In addition, R³ is an alkyl or alkoxyalkyl group, examples of which include, for instance, methyl, ethyl, propyl, butyl, hexyl, decyl, and other linear alkyl groups; isopropyl, *tert*-butyl, isobutyl, and other branched alkyl groups; cycloalkyl and other cyclic alkyl groups; methoxyethyl, ethoxyethyl, methoxypropyl, and other alkoxyalkyl groups. Preferably, such groups are represented by alkyl groups, and especially preferably, by methyl, ethyl, and propyl. In addition, the subscript «a» in the formula above is an integer of from 1 to 3, preferably, 1. Also, the subscript «b» in the formula above is an integer from 1 to 3, preferably, 1. Also, the subscript «c» in the formula above is an integer from 1 to 3, preferably, 3. Here, the subscript «b+c» in the formula above is an integer from 2 to 4. In addition, the subscript «n» in the formula above is an integer of 0 or greater, preferably, an integer from 0 to 100, more preferably, an integer from 1 to 100, still more preferably, an integer from 5 to 100, even more preferably, an integer from 10 to 100, and especially preferably, an integer from 10 to 75.

Processes used for the preparation of such a component (D) include, for instance, a process using a dealcoholation condensation reaction between an organosiloxane having one end of the molecular chain blocked by a silanol group, represented by the general formula:

R¹ ₐR² ₍₃₋ₐ₎SiO(R² ₂SiO)ₙH,

and an alkoxysilane compound having at least two silicon-bonded alkoxy groups per molecule in the presence of an acid catalyst such as acetic acid.

In such a silanol-capped organosiloxane, R¹ in the formula above is a monovalent hydrocarbon group having aliphatic unsaturated bonds, exemplified by the same groups as those mentioned above. In addition, R² in the formula are similar or different monovalent hydrocarbon groups having no aliphatic unsaturated bonds, exemplified by the same groups as those mentioned above. Also, the subscript «a» in the formula above is an integer from 1 to 3, preferably, 1. In addition, the subscript «n» in the formula above is an integer of 0 or greater, preferably, an integer from 0 to 100, more preferably, an integer from 1 to 100, still more preferably, an integer from 5 to 100, even more preferably, an integer from 10 to 100, and especially preferably, an integer from 10 to 75.

Also, the alkoxysilane compounds having at least two silicon-bonded alkoxy groups per molecule are represented by the general formula:

R² _{(4-d})Si(OR³)_{d}

In this alkoxysilane compound, R² in the formula above is a monovalent hydrocarbon group having no aliphatic unsaturated bonds, exemplified by the same groups as those mentioned above. Also, R³ is an alkyl or alkoxyalkyl group, exemplified by the same groups as those mentioned above. In addition, the subscript «d» in the formula above is an integer from 2 to 4, preferably, 4.

Examples of such alkoxysilane compounds include, for instance, dimethoxydimethylsilane, dimethoxydiethylsilane, diethoxydimethylsilane, diethoxydiethylsilane, and other dialkoxydialkylsilane compounds; trimethoxymethylsilane, trimethoxyethylsilane, trimethoxypropylsilane, triethoxymethylsilane, triethoxyethylsilane, and other trialkoxyalkylsilane compounds; tetramethoxysilane, tetraethoxysilane, tetrapropoxysilane, and other tetraalkoxysilane compounds. In addition, examples of the acid catalysts include, for instance, acetic acid, propionic acid, and other fatty acids.

Component (D) is exemplified by the following compounds.

(CH₂=CH)(CH₃)₂SiO[(CH₃)₂SiO]₅Si(OCH₃)₃

(CH₂=CHCH₂)(CH₃)₂SiO[(CH₃)₂SiO]₅Si(OCH₃)₃

(CH₂=CHCH₂CH₂CH₂CH₂)(CH₃)₂SiO[(CH₃)₂SiO]₅Si(OCH₃)₃

(CH₂=CH)(CH₃)₂SiO[(CH₃)₂SiO]₇Si(OCH₃)₃

(CH₂=CH)(CH₃)₂SiO[(CH₃)₂SiO]₇Si(OC₂H₅)₃

(CH₂=CHCH₂)(CH₃)₂SiO[(CH₃)₂SiO]₇Si(OCH₃)₃

(CH₂=CHCH₂CH₂CH₂CH₂)(CH₃)₂SiO[(CH₃)₂SiO]₇Si(OCH₃)₃

(CH₂=CH)(CH₃)₂SiO[(CH₃)₂SiO]₇SiCH₃(OCH₃)₂

(CH₂=CH)(CH₃)₂SiO[(CH₃)₂SiO]₇SiCH₃(OCH₃)₂

(CH₂=CH)(CH₃)₂SiO[(CH₃)₂SiO]₂₅Si(OCH₃)₃

(CH₂=CHCH₂)(CH₃)₂SiO[(CH₃)₂SiO]₂₅Si(OCH₃)₃

(CH₂=CHCH₂CH₂CH₂CH₂)(CH₃)₂SiO[(CH₃)₂SiO]₂₅Si(OCH₃)₃

(CH₂=CH)(CH₃)₂SiO[(CH₃)₂SiO]₂₅Si(OC₂H₅)₃

(CH₂=CH)(CH₃)₂SiO[(CH₃)₂SiO]₂₅SiCH₃(OCH₃)₂

(CH₂=CH)(CH₃)₂SiO[(CH₃)₂SiO]₅₀Si(OCH₃)₃

(CH₂=CHCH₂)(CH₃)₂SiO[(CH₃)₂SiO]₅₀Si(OCH₃)₃

(CH₂=CHCH₂CH₂CH₂CH₂)(CH₃)₂SiO[(CH₃)₂SiO]₅₀Si(OCH₃)₃

(CH₂=CH)(CH₃)₂SiO[(CH₃)₂SiO]₅₀Si(OC₂H₅)₃

(CH₂=CH)(CH₃)₂SiO[(CH₃)₂SiO]₅₀SiCH₃(OCH₃)₂

There are no limitations concerning the content of component (D) so long as the quantity of the component makes it possible to treat of the surface of component (C) to improve its dispersibility in the resultant curable silicone composition for the production of composite soft magnetic materials. Preferably, it is in the range of from 0.05 to 10 parts by weight, more preferably, in the range of from 0.1 to 10 parts by weight, and especially preferably, in the range of from 0.1 to 5 parts by weight per 100 parts by weight of component (C). This is due to the fact that when the content of component (D) is below the lower limit of the above-mentioned ranges, using a large amount of component (C) leads to a decrease in the moldability of the resultant curable silicone composition for the production of composite soft magnetic materials and component (C) tends to easily precipitate and separate when the resultant composite soft magnetic materials are kept in storage, and, on the other hand, to the fact that the physical strength of the resultant composite soft magnetic materials tends to deteriorate when the content exceeds the upper limit of the above-mentioned ranges.

Examples of methods used to treat the surface of component (C) with component (D) include, for instance, mixing component (C) and component (D) to pretreat the surface of component (C) with component (D), or mixing component (A) and component (C) and then adding component (D) to treat the surface of component (C) in component (A) with component (D), with the latter method being preferable. In the thus obtained composition, component (D) may be introduced as a result of treating the surface of component (C) or as a result of separately introducing it in the present composition.

So long as the purpose of the present invention is not impaired, other optional components, for instance, fillers such as fumed silica, precipitated silica, and fumed titanium oxide, as well as fillers obtained by making the surface of the above-mentioned fillers hydrophobic by treating it with organosilicon compounds; and, in addition, pigments, dyes, fluorescent dyes, heat-resistant additives, triazole compounds and other flame retardancy-imparting agents, plasticizers, and adhesion-imparting agents may be introduced into the present composition. In particular, when the present composition is cured by a hydrosilation reaction, to improve the handleability of the present composition, the composition preferably contains 2-methyl-3-butyn-2-ol, 2-phenyl-3-butyn-2-ol, 1-ethynyl-1-cyclohexanol, and other acetylene compounds, 3-methyl-3-penten-1-yne, 3,5-dimethyl-3-hexen-1-yne, and other ene-yne compounds, phosphine compounds, mercaptan compounds, and other cure reaction inhibitors. Although there are no limitations concerning the content of the cure reaction inhibitors, preferably, the content should be in the range of from 0.001 to 1.0 % by weight relative to the present composition.

Next, detailed explanations are provided regarding the composite soft magnetic materials of the present invention.

The composite soft magnetic materials of the present invention are characterized by the fact that they are obtained by curing the above-mentioned composition. There are no limitations concerning the methods used to cure the above-mentioned composition, which may be, for instance, molding the above-mentioned composition and then allowing it to stand at room temperature, molding the above-mentioned composition and then heating it to 50 - 200°C, or using injection molding. In addition, there are no limitations concerning the consistency of the thus obtained composite soft magnetic materials, which may be, for instance, high-hardness rubber-like, low-hardness rubber-like, or gel-like. In addition, there are no limitations concerning the shape of the composite soft magnetic materials, which may be, for instance, sheet-shaped, in addition to variously shaped articles molded using a mold. Such sheet-shaped composite soft magnetic materials are exemplified by materials having peelable film adhered to both sides thereof, or materials having film permanently integrated therewith on one side and peelable film adhered thereto on the other side.

Methods used to fabricate sheet-shaped composite soft magnetic materials are exemplified by a process, in which the above-mentioned composition is sandwiched between sheets of film that can be peeled from the cured product of the above-mentioned composition, and, in this state, subjected to pressure to produce the desired thickness and cured by heating. The heating can be carried out simultaneously with pressure application or in an oven after removing from the press.

In addition, methods used to fabricate sheet-shaped composite soft magnetic materials with film integrated therewith on one side are exemplified by a process, in which the above-mentioned composition is sandwiched between a sheet of film that can be peeled from the cured product of the above-mentioned composition and a sheet of easily adhesive film whose surface, if necessary, can be primed with silane coupling agents, titanium coupling agents, aluminum coupling agents, etc. or treated with plasma, corona discharge, or alkali in advance, and, in this state, subjected to pressure to produce the desired thickness and cured by heating.

### Examples

The curable silicone composition for the production of composite soft magnetic materials and composite soft magnetic materials of the present invention are explained in detail below by referring to application examples and comparative examples. In addition, characteristics reported in the application examples are values measured at 25°C. Also, in the application examples, the organosiloxane oligomer represented by the formula:

(CH₂=CH)(CH₃)₂SiO[(CH₃)₂SiO]₂₅Si(OCH₃)₃

was prepared via a methanol-eliminating condensation reaction carried out by combining an organosiloxane oligomer represented by the formula:

(CH₂=CH)(CH₃)₂SiO[(CH₃)₂SiO]₂₅OH

with tetramethoxysilane (in the amount of 10 mol per 1 mol of the above-mentioned organosiloxane oligomer) and heating the mixture in the presence of an acetic acid catalyst.

In addition, the moldability of the curable silicone composition for the production of composite soft magnetic materials was evaluated in the following manner.

### [Moldability of curable silicone composition for the production of composite soft magnetic materials]

After sandwiching the curable silicone composition for the production of composite soft magnetic materials between sheets of ethylene tetrafluoride resin film with a thickness of 0.2 mm and making the composition into a layer with a thickness of 2 mm, the above-mentioned composition was cured by heating at 120°C for 60 minutes. Subsequently, the ethylene tetrafluoride resin film was peeled off, and evaluation was carried out to determine whether a sheet-shaped composite soft magnetic material had been obtained, designating the results of the evaluation as ○, i.e. excellent moldability, when it was possible to mold a uniform composite soft magnetic material, and ×, i.e. poor moldability, when it proved impossible to mold a uniform composite soft magnetic material.

In addition, the electromagnetic wave absorption characteristics, flame retardancy, and the thermal conductivity of the composite soft magnetic materials were measured in the following manner.

### [Electromagnetic wave absorption characteristics of composite soft magnetic materials]

After sandwiching the curable silicone composition for the production of composite soft magnetic materials between sheets of polypropylene resin film with a thickness of 0.2 mm and making the composition into a layer with a thickness of 0.5 mm, the above-mentioned composition was cured by heating at 120°C for 60 minutes, whereupon the polypropylene resin film was peeled off, producing a sheet of composite soft magnetic material. The magnetic permeability of the composite soft magnetic material was measured at a frequency of 10 MHz using the RF Impedance/material Analyzer 4291B from Agilent Technologies. Also, since the electromagnetic wave absorption performance of soft magnetic materials is based on energy absorption due to magnetic resonance phenomena and the magnetic resonance-induced energy absorption increases with the magnetic permeability of the materials, here, the electromagnetic wave absorption characteristics were evaluated by measuring the magnetic permeability of the materials.

### [Flame retardancy of composite soft magnetic materials]

After sandwiching the curable silicone composition for the production of composite soft magnetic materials between sheets of ethylene tetrafluoride resin film with a thickness of 0.2 mm and making the composition into a layer with a thickness of 0.5 mm, the above-mentioned composition was cured by heating at 120°C for 60 minutes. Subsequently, the ethylene tetrafluoride resin film was peeled off, producing a sheet of composite soft magnetic material, whose flame retardancy was evaluated using the UL 94 20-mm Vertical Burning Test.

### [Thermal conductivity of composite soft magnetic materials]

After molding the curable silicone composition for the production of composite soft magnetic materials into a sheet with a thickness of 15 mm, the above-mentioned composition was cured by heating at 120°C for 60 minutes. The thermal conductivity of the resultant composite soft magnetic material was measured using the Quick Thermal Conductivity Meter QTM-500 from Kyoto Electronics Manufacturing Co., Ltd. in accordance with the hot-wire method specified in JIS R2616.

### [Application Example 1]

9.87 parts by weight of dimethylpolysiloxane with a viscosity of 400 mPa·s (vinyl group content = 0.44 % by weight) having both ends of the molecular chain blocked by dimethylvinylsiloxy groups, 20.58 parts by weight of dimethylpolysiloxane with a viscosity of 35,000 mPa·s (vinyl group content = 0.09 % by weight) having both ends of the molecular chain blocked by dimethylvinylsiloxy groups, 67.5 parts by weight of Fe-Si-Cr alloy powder with a D₅₀ (particle size obtained when the value of 50 % is reached in the process of summing up weight starting from small particle sizes, as determined using a particle size meter) of 15 *µ*m and a specific surface area of 1.4 m²/g, which was prepared in accordance with the method described in Japanese Patent Publication No. 2,523,388 and subjected to pulverizing treatment to impart it with an oblate shape and oxidizing treatment to create an oxide film on its surface, and 1.0 parts by weight of organosiloxane oligomer represented by the formula:

(CH₂=CH)(CH₃)₂SiO[(CH₃)₂SiO]₂₅Si(OCH₃)₃

were mixed in a mixer, thereby treating the surface of the above-mentioned alloy powder with said organosiloxane oligomer.

Next, 0.9 parts by weight of copolymer of methylhydrogensiloxane and dimethylsiloxane having both ends of the molecular chain blocked by trimethylsiloxy groups (silicon-bonded hydrogen atom content = 0.74 % by weight), which had a viscosity of 5 mPa·s and an average of five silicon-bonded hydrogen atoms per molecule, and, as a cure reaction inhibitor, 0.05 parts by weight of 1-ethynyl-1-cyclohexanol were combined therewith.

Finally, a silicone rubber composition for the production of composite soft magnetic materials was prepared by combining the above-mentioned mixture with 0.1 parts by weight of complex of platinum and 1,3-divinyl-1,1,3,3-tetramethyldisiloxane with a platinum content of 0.5 % by weight. The moldability of the silicone rubber composition for the production of composite soft magnetic materials and the characteristics of the sheet-shaped composite soft magnetic material obtained by curing it are listed in Table 1.

### [Application Example 2]

19.92 parts by weight of dimethylpolysiloxane with a viscosity of 10,000 mPa·s (vinyl group content = 0.12 % by weight) having both ends of the molecular chain blocked by dimethylvinylsiloxy groups, 77.5 parts by weight of Fe-Si-Cr alloy powder with a D₅₀ (particle size obtained when the value of 50 % is reached in the process of summing up weight starting from small particle sizes, as determined using a particle size meter) of 15 *µ*m and a specific surface area of 0.4 m²/g, which was prepared in accordance with the method described in Japanese Patent Publication No. 2,523,388 and subjected to pulverizing treatment to impart it with an oblate shape and oxidizing treatment to create an oxide film on its surface, and 1.0 parts by weight of organosiloxane oligomer represented by the formula:

(CH₂=CH)(CH₃)₂SiO[(CH₃)₂SiO]₂₅Si(OCH₃)₃

were mixed in a mixer, thereby treating the surface of the above-mentioned alloy powder with said organosiloxane oligomer.

Next, 1.43 parts by weight of copolymer of methylhydrogensiloxane and dimethylsiloxane having both ends of the molecular chain blocked by trimethylsiloxy groups (silicon-bonded hydrogen atom content = 0.13 % by weight), which had a viscosity of 20 mPa·s and an average of three silicon-bonded hydrogen atoms per molecule, and, as a cure reaction inhibitor, 0.05 parts by weight of 1-ethynyl-1-cyclohexanol were combined therewith.

Finally, a silicone rubber composition for the production of composite soft magnetic materials was prepared by combining the above-mentioned mixture with 0.1 parts by weight of complex of platinum and 1,3-divinyl-1,1,3,3-tetramethyldisiloxane with a platinum content of 0.5 % by weight. The moldability of the silicone rubber composition for the production of composite soft magnetic materials and the characteristics of the sheet-shaped composite soft magnetic material obtained by curing it are listed in Table 1.

### [Application Example 3]

3.89 parts by weight of dimethylpolysiloxane with a viscosity of 400 mPa·s (vinyl group content = 0.44 % by weight) having both ends of the molecular chain blocked by dimethylvinylsiloxy groups, 8.11 parts by weight of dimethylpolysiloxane with a viscosity of 35,000 mPa·s (vinyl group content = 0.09 % by weight) having both ends of the molecular chain blocked by dimethylvinylsiloxy groups, 86.5 parts by weight of Mn-Mg-Zn ferrite powder with a D₅₀ (particle size obtained when the value of 50 % is reached in the process of summing up weight starting from small particle sizes, as determined using a particle size meter) of 10 *µ*m and a specific surface area of 0.5 m²/g, which was prepared in accordance with the method described in Japanese Patent Publication No. Sho 54-27557 and subjected to pulverizing treatment, and 1.0 parts by weight of organosiloxane oligomer represented by the formula:

(CH₂=CH)(CH₃)₂SiO[(CH₃)₂SiO]₂₅Si(OCH₃)₃

were mixed in a mixer, thereby treating the surface of the above-mentioned ferrite powder with said organosiloxane oligomer.

Next, 0.35 parts by weight of copolymer of methylhydrogensiloxane and dimethylsiloxane having both ends of the molecular chain blocked by trimethylsiloxy groups (silicon-bonded hydrogen atom content = 0.74 % by weight), which had a viscosity of 5 mPa·s and an average of five silicon-bonded hydrogen atoms per molecule, and, as a cure reaction inhibitor, 0.05 parts by weight of 1-ethynyl-1-cyclohexanol were combined therewith.

Finally, a silicone rubber composition for the production of composite soft magnetic materials was prepared by combining the above-mentioned mixture with 0.1 parts by weight of complex of platinum and 1,3-divinyl-1,1,3,3-tetramethyldisiloxane with a platinum content of 0.5 % by weight. The moldability of the silicone rubber composition for the production of composite soft magnetic materials and the characteristics of the sheet-shaped composite soft magnetic material obtained by curing it are listed in Table 1.

### [Comparative Example 1]

A silicone rubber composition for the production of composite soft magnetic materials was prepared in the same manner as in Application Example 1, with the exception that the organosiloxane oligomer represented by the formula:

(CH₂=CH)(CH₃)₂SiO[(CH₃)₂SiO]₂₅Si(OCH₃)₃

was not added as in Application Example 1. The moldability of the silicone rubber composition for the production of composite soft magnetic materials and the characteristics of the sheet-shaped composite soft magnetic material obtained by curing it are listed in Table 1.

### [Comparative Example 2]

A silicone rubber composition for the production of composite soft magnetic materials was prepared in the same manner as in Application Example 1, with the exception that an organosiloxane oligomer represented by the formula:

(CH₃)₃SiO[(CH₃)₂SiO]₂₃Si(OCH₃)₃

as added, in the same amount, instead of the organosiloxane oligomer represented by the formula:

(CH₂=CH)(CH₃)₂SiO[(CH₃)₂SiO]₂₅Si(OCH₃)₃

The moldability of the silicone rubber composition for the production of composite soft magnetic materials and the characteristics of the sheet-shaped composite soft magnetic material obtained by curing it are listed in Table 1.

### [Comparative Example 3]

A silicone rubber composition for the production of composite soft magnetic materials was prepared in the same manner as in Application Example 3, with the exception that the organosiloxane oligomer represented by the formula:

(CH₂=CH)(CH₃)₂SiO[(CH₃)₂SiO]₂₅Si(OCH₃)₃

was not added as in Application Example 3. The moldability of the silicone rubber composition for the production of composite soft magnetic materials and the characteristics of the sheet-shaped composite soft magnetic material obtained by curing it are listed in Table 1.

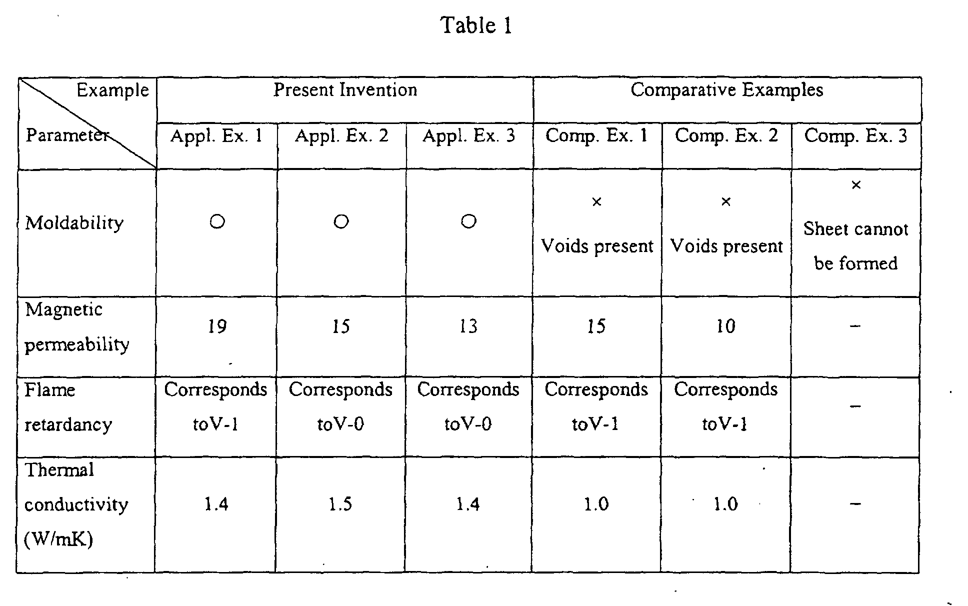

### Industrial Applicability

The inventive curable silicone composition for the production of composite soft magnetic materials permits preparation of the above-mentioned composite soft magnetic materials with excellent moldability despite containing a large amount of a soft magnetic powder used to obtain a composite soft magnetic material of superior electromagnetic wave absorption characteristics. In addition, the composite soft magnetic materials of the present invention can provide electromagnetic noise-canceling materials for electronic equipment of superior electromagnetic wave absorption characteristics and superior flame retardancy and thermal conductivity, and, furthermore, can provide electromagnetic noise-canceling materials ensuring reduced environmental load due to their flame retardancy even if halide material is not contained.

## Claims

1. A curable silicone composition for the production of composite soft magnetic materials, which comprises at least: (A) a curable organopolysiloxane, (B) a curing agent, (C) a soft magnetic powder, and (D) an organosiloxane represented by the general formula:
[R¹ ₐR² ₍₃₋ₐ₎SiO(R² ₂SiO)ₙ]_{b}SiR² _{[4-(b+c)]}(OR³)_{c}
(where R¹ is a monovalent hydrocarbon group having an aliphatic unsaturated bond or bonds, R² are similar or different monovalent hydrocarbon groups having no aliphatic unsaturated bonds, R³ is an alkyl group or an alkoxyalkyl group, the subscript «a» is an integer from 1 to 3, the subscript «b» is an integer from 1 to 3, the subscript «c» is an integer from 1 to 3, the subscript «b+c» is an integer from 2 to 4 and the subscript «n» is an integer of 0 or greater).

2. The composition of claim 1, wherein the curable silicone composition is cured by a hydrosilation reaction.

3. The composition of claim 1, wherein component (C) is a soft magnetic metal powder or a magnetic oxide powder (ferrite powder).

4. The composition of claim 3, wherein the soft magnetic metal powder is an oblate metal powder whose surface has been subjected to oxidizing treatment.

5. The composition of claim 1, wherein the content of component (C) is from 40 to 1,000 parts by weight per 100 parts by weight of component (A).

6. The composition of claim 1, wherein the content of component (D) is from 0.05 to 10 parts by weight per 100 parts by weight of component (C).

7. A composite soft magnetic material obtained by curing the curable silicone composition according to any one of claims 1 through 6.

8. The composite soft magnetic material of claim 7, wherein the material is sheet-shaped.
